(19) **Europäisches Patentamt**

**European Patent Office**

**Office européen des brevets**

(11) **EP 1 568 129 B1**

(12) **FASCICULE DE BREVET EUROPEEN**

(45) Date de publication et mention
de la délivrance du brevet:
**14.06.2006 Bulletin 2006/24**

(21) Numéro de dépôt: **03789511.7**

(22) Date de dépôt: **27.11.2003**

(51) Int Cl.:
***H03H 9/05*** (2006.01)

(86) Numéro de dépôt international:
**PCT/FR2003/003500**

(87) Numéro de publication internationale:
**WO 2004/051848 (17.06.2004 Gazette 2004/25)**

(54) **SUPPORT POUR RESONATEUR ACOUSTIQUE, RESONATEUR ACOUSTIQUE ET CIRCUIT INTEGRE CORRESPONDANT**

HALTERUNG FÜR AKUSTISCHEN RESONATOR, AKUSTISCHER RESONATOR UND ENTSPRECHENDE INTEGRIERTE SCHALTUNG

ACOUSTIC RESONATOR SUPPORT, ACOUSTIC RESONATOR AND CORRESPONDING INTEGRATED CIRCUIT

(84) Etats contractants désignés:
**DE FR GB IT**

(30) Priorité: **28.11.2002 FR 0214967**

(43) Date de publication de la demande:
**31.08.2005 Bulletin 2005/35**

(73) Titulaire: **STMicroelectronics S.A.**
**92120 Montrouge (FR)**

(72) Inventeurs:
• **BOUCHE, Guillaume**
**F-38000 Grenoble (FR)**
• **CARUYER, Grégory**
**F-38570 Goncelin (FR)**
• **ANCEY, Pascal**
**F-38420 Revel (FR)**

(74) Mandataire: **Casalonga, Axel et al**
**Bureau Casalonga & Josse**
**Bayerstrasse 71/73**
**80335 München (DE)**

(56) Documents cités:
**EP-A- 1 158 671**        **US-A- 5 873 154**
**US-A1- 2001 028 285**        **US-A1- 2002 172 766**

**Description**

L'invention concerne le domaine des circuits intégrés, et plus particulièrement des circuits intégrés comprenant un ou plusieurs résonateurs acoustiques ou piézoélectriques.

De tels circuits peuvent être utilisés dans des applications de traitement du signal, par exemple en servant dans une fonction de filtrage.

Les résonateurs acoustiques sont solidaires du circuit intégré tout en devant être isolés acoustiquement ou mécaniquement par rapport à ceux-ci. A cet effet, on peut prévoir un support apte à réaliser une telle isolation. Le support peut comprendre une alternance de couche à forte impédance acoustique et de couche à faible impédance acoustique, voir le document US 6 081 171.

On entend par impédance acoustique la grandeur Z produit de la densité du matériau p par la vitesse acoustique v. Soit

Z=p x v. Pour v, vitesse acoustique, on peut prendre comme - définition :

$$v = (\rho \times C_{33})^{1/2}$$

où $C_{33}$ est un des coefficients de la matrice de compliance élastique.

Pour des performances d'isolation acoustique élevées, il est souhaitable que la différence d'impédance acoustique entre les matériaux soit la plus forte possible.

L'invention vise à répondre à ce besoin.

L'invention propose un support pour résonateur acoustique à haut pouvoir d'isolation acoustique.

Le support pour résonateur acoustique, selon un aspect de l'invention, comprend au moins un ensemble bicouche comprenant une couche de matériau à forte impédance acoustique et une couche de matériau à faible impédance acoustique réalisé en matériau à faible permittivité électrique. En effet, on s'est aperçu que la faible permittivité électrique va de pair avec la faible impédance acoustique. Dans un tel matériau, une onde acoustique se propage lentement.

Avantageusement, la permittivité électrique relative du matériau à faible impédance acoustique est inférieure à 4, préférablement inférieure à 3, ou encore mieux inférieure à 2,5.

Avantageusement, la couche de matériau à faible impédance acoustique est réalisée à partir d'un des matériaux utilisés pour la fabrication du reste du circuit dont elle fait partie, par exemple pour la fabrication des niveaux d'interconnexions.

Le matériau à faible impédance acoustique comprend du SiOC. Le SiOC est un matériau parfois utilisé pour réaliser des couches diélectriques à très faible permittivité sur un substrat ou dans les interconnexions. De préférence, on pourra utiliser du SiOC poreux dont l'impédance acoustique est encore plus faible. Les pores d'un tel matériau sont généralement remplis d'un gaz tel que de l'argon.

Dans un mode de réalisation préféré de l'invention, le support comprend un seul ensemble bicouche. Le support est ainsi particulièrement compact et économique. Dans un autre mode de réalisation de l'invention, on peut prévoir un support à deux ensembles bicouche assurant une excellente isolation acoustique tout en restant plus compact et économique que les supports connus qui comprennent en général au moins trois ensembles bicouche. Toutefois, si le support selon l'invention comprend trois ou plus ensembles bicouche, les caractéristiques d'isolation acoustique seront très nettement améliorées à compacité constante.

Dans un mode de réalisation de l'invention, le matériau à forte impédance acoustique comprend au moins une des espèces suivantes : nitrure d'aluminium, cuivre, nickel, tungstène, or, platine, molybdène. Le nitrure d'aluminium pourra se présenter sous sa forme amorphe et être avantageux car souvent utilisé pour réaliser d'autres couches du circuit. Le cuivre a une impédance acoustique inférieure à celle du tungstène mais présente un intérêt en raison de son utilisation fréquente dans les interconnexions du circuit. Une couche de cuivre du support peut ainsi être réalisée au cours d'une étape de fabrication commune avec des interconnexions. Le tungstène offre une impédance acoustique particulièrement élevée.

Dans un mode de réalisation de l'invention, la couche de matériau à forte impédance acoustique est d'épaisseur comprise entre 0,3 et 3,2 $\mu$m.

Dans un mode de réalisation de l'invention, la couche de matériau à faible impédance acoustique présente une épaisseur comprise entre 0,3 et 0,7 $\mu$m.

L'invention propose également un résonateur acoustique comprenant un élément actif et un support. Le support comprend au moins un ensemble bicouche comprenant une couche de matériau à forte impédance acoustique et une couche de matériau à faible impédance acoustique réalisées en matériau à faible permittivité électrique.

Le matériau à faible impédance acoustique comprend de SiOC.

Dans un mode de réalisation de l'invention, l'élément actif comprend au moins une couche piézoélectrique disposée entre deux électrodes. Une électrode inférieure peut reposer sur le support. La couche piézoélectrique peut être réalisée en nitrure d'aluminium cristallin. Le support sert d'interface entre l'élément actif et le reste d'un circuit.

L'invention propose également un circuit intégré comprenant un substrat, un ensemble d'interconnexions et un résonateur acoustique pourvu d'un élément actif et d'un support. Le support comprend au moins un ensemble bicouche comprenant une couche de matériau à forte impédance acoustique et une couche de matériau à faible impédance acoustique réalisées en matériau à faible permittivité électrique.

Le matériau à faible impédance acoustique comprend de SiOC.

Dans un mode de réalisation de l'invention, le résonateur acoustique est disposé sur l'ensemble d'interconnexions, par exemple en étant supporté par une couche diélectrique supérieure de l'ensemble d'interconnexions.

Dans un autre mode de réalisation de l'invention, le résonateur acoustique est disposé au niveau de l'ensemble d'interconnexions, l'électrode supérieure de l'élément actif du résonateur acoustique peut affleurer la surface supérieure de l'ensemble d'interconnexions.

Avantageusement, au moins un matériau est commun entre le support et le substrat ou l'ensemble d'interconnexions. Du cuivre peut servir à la fois à la couche de matériau à forte impédance acoustique du support et aux lignes de métallisation de l'ensemble d'interconnexions. De préférence, on prévoira une étape de fabrication commune de ladite couche de matériau à forte impédance acoustique du support et des niveaux de métallisation de l'ensemble d'interconnexions.

Une couche de matériau à faible impédance acoustique peut être disposée au même niveau qu'une couche d'interconnexion.

La présente invention sera mieux comprise et d'autres avantages apparaîtront à la lecture de la description détaillée de quelques modes de réalisation pris à titre d'exemples nullement limitatifs et illustrés par les dessins annexés, sur lesquels :

- la figure 1 est une vue schématique d'un circuit intégré selon un premier mode de réalisation de l'invention ;
- la figure 2 est une vue schématique d'un circuit intégré selon un deuxième mode de réalisation de l'invention ; et
- la figure 3 est une vue schématique d'un résonateur acoustique selon un aspect de l'invention.

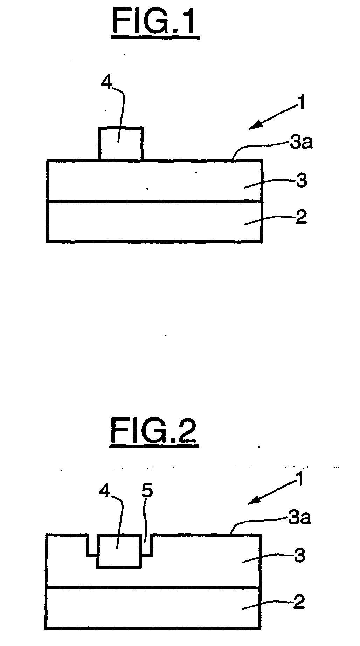

Comme on peut le voir sur la figure 1, un circuit intégré 1 comprend un substrat 2 dans lequel sont généralement formées des zones actives non-représentécs, et un ensemble d'interconnexions 3 disposé au-dessus du substrat 2 et, en contact avec sa surface supérieure, et pourvue d'au moins un niveau de métallisation permettant de réaliser des interconnexions entre des éléments du substrat.

Le circuit intégré 1 se complète par un résonateur mécanique 4 disposé au-dessus de l'ensemble d'interconnexions 3 en contact avec sa surface supérieure 3a. Le résonateur mécanique 4 supporté par l'ensemble d'interconnexions 3 sera également pourvu de connexions électrique non représentées.

Dans le mode de réalisation illustré sur la figure 2, le résonateur acoustique 4 est disposé dans l'ensemble d'interconnexions 3 et affleure sa surface supérieure 3a. Cette réalisation permet une meilleure compacité du circuit intégré 1. Une partie inférieure du résonateur acoustique 4 peut être noyée dans l'ensemble d'interconnexions 3 tandis qu'une partie supérieure sera laissée libre de façon à pouvoir vibrer en étant séparée du reste de l'ensemble d'interconnexions 3 par une rainure 5. La rainure 5 assure l'isolation du composant dans les directions latérales, c'est-à-dire autorise les couches à vibrer sans interférence directe avec le substrat. L'épaisseur de la rainure 5 peut être faible, par exemple inférieure à 1 $\mu$m.

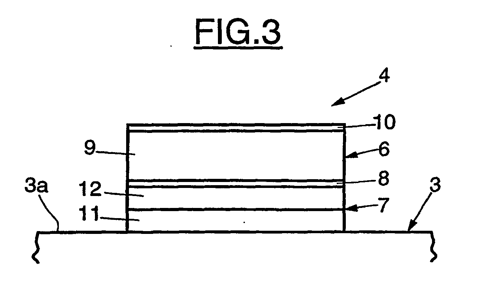

La structure du résonateur acoustique 4 est décrite plus en détail en référence à la figure 3.

Le résonateur acoustique 4 comprend un élément actif 6 et un support 7 qui repose sur la surfacé supérieure 3a de l'ensemble d'interconnexions 3 et supporte l'élément actif 6.

L'élément actif 6 comprend 3 couches principales sous la forme d'une électrode inférieure 8, d'une couche piézoélectrique 9 et d'une électrode supérieure 10. Les électrodes 8 et 10 sont reliées électriquement de façon non représentée à des conducteurs prévus dans l'ensemble d'interconnexions 3. Les électrodes 8 et 10 sont réalisées en matériau conducteur, par exemple l'aluminium, le cuivre, le platine, le molybdène, le nickel, le titane, le niobium, l'argent, l'or, le tantale, le lanthane, etc. La couche piézoélectrique 9 disposée entre les électrodes 8 et 10 peut être réalisée, à titre d'exemple, en nitrure d'aluminium cristallin, en oxyde de zinc, en sulfure de zinc, en céramique de type LiTaO, PbTiO, PbZrTi, KNbO$_3$, ou encore contenant du lanthane, etc.

La couche piézoélectrique 9 peut avoir une épaisseur de quelques $\mu$m, par exemple 2,4 $\mu$m. Les électrodes 8 et 10 peuvent avoir une épaisseur nettement inférieure à celle de la couche piézoélectrique 9, par exemple 0,1 $\mu$m.

Le support 7 comprend une couche à forte impédance acoustique 11 reposant sur la surface supérieure 3a de l'ensemble d'interconnexions 3 et une couche à faible impédance acoustique 12 qui supporte l'électrode inférieure 8.

La couche à forte impédance acoustique 11 pourra être réalisée en un matériau dense tel que le nitrure d'aluminium amorphe, le cuivre, le nickel, le tungstène, l'or, ou le molybdène. Des alliages ou des superpositions de sous-couches de ces espèces peuvent être envisagés. Le tungstène offre une impédance acoustique extrêmement forte et peut être obtenu de façon à éviter les contraintes résiduelles de fabrication, notamment en environnement xénon, par exemple par un plasma xénon. Le cuivre offre des caractéristiques d'impédance acoustique moins favorables que le tungstène, mais présente l'avantage d'être souvent utilisé dans les ensembles d'interconnexions pour former les lignes conductrices. Son utilisation dans la couche à forte impédance acoustique 11 peut permettre de réaliser ladite couche 11 par la même étape de fabrication que celle de ligne conductrice de l'ensemble d'interconnexions, ce qui est particulièrement économique.

La couche à faible impédance acoustique est réalisée en matériau à faible permittivité électrique en raison de la correspondance entre la faible permittivité électrique et la faible impédance acoustique. La permittivité du matériau de la couche 12 est inférieure à 4; Toutefois, on préférera prendre un matériau de permittivité inférieure à 3, par exemple un matériau diélectrique de permittivité de l'ordre de 2,9, souvent utilisé comme couche diélectrique dans les zones actives du substrat ou dans l'ensemble d'interconnexions 3. Là encore, une même étape de fabrication peut servir à former la couche 12 et une couche diélectrique de l'ensemble d'interconnexions 3. On pourra par exemple prendre du SiOC ou un matériau à base de SiOC. Il est encore plus avantageux de réaliser la couche 12 en un matériau à permittivité ultrafaible, inférieure à 2,5, par exemple de l'ordre de 2,0. A cet effet, on pourra réaliser la couche 12 en SiOC poreux ou à base d'un tel matériau.

On comprend qu'il est particulièrement avantageux d'un point de vue économique, de réaliser le support 7 à partir d'espèces chimiques utilisées pour la fabrication de l'ensemble d'interconnexions. On peut alors profiter des étapes de fabrication dudit ensemble d'interconnexions pour réaliser le support 7. On évite ainsi des étapes supplémentaires et un allongement du processus de fabrication.

Comme le matériau à faible impédance acoustique de la couche 12 offre une différence d'impédance acoustique très élevée par rapport à celle de la couche 11, l'isolation acoustique et/ou mécanique assurée par la couche 7 entre l'élément actif 6 et le reste du circuit intégré s'en trouve améliorée. Il en découle que l'on peut réduire le nombre de paires de couches 11 et 12 de la couche 7 à caractéristiques d'isolation égales. Ainsi, une application nécessitant de façon classique 3 ou 4 paires de couches pourra être réalisée avec seulement une ou deux paires de couches 11 et 12 d'où un gain de compacité du résonateur acoustique et une diminution des coûts. Sur la figure 3, on a représenté un support 7 à une paire de couches 11 et 12. Toutefois, on peut prévoir un support 7 à deux paires de couches 11 et 12 superposées ou encore à trois ou plus paires de couches 11 et 12, ce qui offre alors des caractéristiques d'isolation acoustique de très haut niveau.

A noter qu'un résonateur peut comporter un nombre impair de couches, dans le cas ou on dispose une première couche à faible impédance acoustique sous un ou plusieurs bicouches.

L'épaisseur de la couche à faible impédance acoustique 12 dépend de 1a fréquence de résonance prévue de l'élément actif 6 et pourrait être avantageusement dimensionné avec une épaisseur de l'ordre du quart de la longueur d'onde. La couche 12 peut avoir une épaisseur de l'ordre de quelques dixièmes de microns, préférablement inférieure à 0,7 $\mu$m, par exemple de 0,2 $\mu$m à 0,7 $\mu$m. L'épaisseur de la couche à forte impédance acoustique 11 peut être de l'ordre de quelques dixièmes de microns, par exemple 0,3 $\mu$m à 3,2 $\mu$m.

L'invention offre donc un support pour résonateur acoustique ayant une impédance acoustique très élevée comprise entre $30 \times 10^{-6}$ et $130 \times 10^{-6}$ kg m$^{-2}$ s$^{-1}$. On peut ainsi bénéficier d'un résonateur acoustique et d'un circuit intégré plus compact et plus économique en raison de la réduction du nombre de couches.

**Revendications**

1. Support (7) pour résonateur acoustique (4), comprenant au moins un ensemble bicouche comprenant une couche (11) de matériau à forte impédance acoustique et une couche (12) de matériau à faible impédance acoustique réalisée en matériau à faible permittivité électrique, **caractérisé par le fait que** le matériau à faible impédance acoustique comprend du SiOC.

2. Support selon la revendication 1, **caractérisé par le fait que** la permittivité électrique du matériau à faible impédance acoustique est inférieure à 4, préférablement inférieure à 3.

3. Support selon la revendication 2, **caractérisé par le fait que** la permittivité électrique relative du matériau à faible impédance acoustique est inférieure à 2,5.

4. Support selon la revendication 1, **caractérisé par le fait que** le matériau à faible impédance acoustique comprend du SiOC poreux.

5. Support selon l'une quelconque des revendications précédentes, **caractérisé par le fait qu'**il comprend un ou deux ensembles bicouches.

6. Support selon l'une quelconque des revendications précédentes, **caractérisé par le fait que** le matériau à forte impédance acoustique comprend au moins une des espèces suivantes: nitrure d'aluminium, cuivre, nickel, tungstène, or, platine, molybdène.

7. Support selon l'une quelconque des revendications précédentes, **caractérisé par le fait que** la couche de matériau à forte impédance acoustique est d'épaisseur comprise entre 0,3 et 3,2 $\mu$m.

8. Support selon l'une quelconque des revendications précédentes, **caractérisé par le fait que** la couche de matériau à faible impédance acoustique est d'épaisseur inférieure à 0,7 $\mu$m, préférablement comprise entre 0,3 et 0,7 $\mu$m.

9. Résonateur acoustique (4) comprenant un élément actif (6) et un support (7) selon la revendication 1.

10. Résonateur selon la revendication 9, **caractérisé par le fait que** l'élément actif (6) comprend au moins une couche piézoélectrique (9) disposée entre des électrodes (8, 10).

11. Circuit intégré (1) comprenant un substrat. (2), un ensemble d'interconnexions et un résonateur acoustique (4) pourvu d'un élément actif (6) et d'un support (7) selon la revendication 1.

12. Circuit selon la revendication 11, **caractérisé par le fait que** le résonateur acoustique (4) est disposé sur l'ensemble d'interconnexions (3).

13. Circuit selon la revendication 11, **caractérisé par le fait que** le résonateur acoustique (4) est disposé au niveau de l'ensemble d'interconnexions (3).

14. Circuit selon l'une quelconque des revendications 11 à 13, **caractérisé par le fait qu'**une couche de matériau à faible impédance acoustique est disposée au même niveau qu'une couche d'interconnexion.


**Claims**

1. Support (7) for an acoustic resonator (4), comprising at least one bilayer assembly comprising a layer (11) of high-acoustic-impedance material and a layer (12) of low-acoustic-impedance material made of a low-electrical-permittivity material, **characterized in that** the low-acoustic-impedance material comprises SiOC.

2. Support according to Claim 1, **characterized in that** the electrical permittivity of the low-acoustic-impedance material is less than 4, preferably less than 3.

3. Support according to Claim 2, **characterized in that** the relative electrical permittivity of the low-acoustic-impedance material is less than 2.5.

4. Support according to Claim 1, **characterized in that** the low-acoustic-impedance material comprises porous SiOC.

5. Support according to any one of the preceding claims, **characterized in that** it includes one or two bilayer assemblies.

6. Support according to any one of the preceding claims, **characterized in that** the high-acoustic-impedance material includes at least one of the following species: aluminium nitride, copper, nickel, tungsten, gold, platinum, molybdenum.

7. Support according to any one of the preceding claims, **characterized in that** the layer of high-acoustic-impedance material has a thickness of between 0.3 and 3.2 μm.

8. Support according to any one of the preceding claims, **characterized in that** the layer of low-acoustic-impedance material has a thickness of less than 0.7 μm, preferably between 0.3 and 0.7 μm.

9. Acoustic resonator (4) comprising an active element (6) and a support (7) according to Claim 1.

10. Resonator according to Claim 9, **characterized in that** the active element (6) includes at least one piezoelectric layer (9) placed between electrodes (8, 10) .

11. Integrated circuit (1) comprising a substrate (2), a set of interconnects and an acoustic resonator (4) that is provided with an active element (6) and with a support (7) according to Claim 1.

12. Circuit according to Claim 11, **characterized in that** the acoustic resonator (4) is placed on the set of interconnects (3).

13. Circuit according to Claim 11, **characterized in that** the acoustic resonator (4) is placed near the set of interconnects (3).

14. Circuit according to any one of Claims 11 to 13, **characterized in that** a layer of low-acoustic-impedance material is placed at the same level as an interconnect layer.


**Patentansprüche**

1. Halterung (7) für einen akustischen Resonator (4), die mindestens eine Doppelschichtanordnung aufweist, die eine Schicht (11) aus einem Material mit hoher akustischer Impedanz und eine Schicht (12) aus einem Material mit niedriger akustischer Impedanz, realisiert aus einem Material mit niedriger elektrischer Permittivität, aufweist, **dadurch gekennzeichnet, daß** das Material mit niedriger akustischer Impedanz SiOC aufweist.

2. Halterung nach Anspruch 1, **dadurch gekennzeichnet, daß** die elektrische Permittivität des Materials mit niedriger akustischer Impedanz kleiner als 4, vorzugsweise kleiner als 3, ist.

3. Halterung nach Anspruch 2, **dadurch gekennzeichnet, daß** die relative elektrische Permittivität des Materials mit niedriger akustischer Impedanz kleiner als 2,5 ist.

4. Halterung nach Anspruch 1, **dadurch gekennzeichnet, daß** das Material mit niedriger akustischer Impedanz poröses SiOC aufweist.

5. Halterung nach einem der vorstehenden Ansprüche, **dadurch gekennzeichnet, daß** sie eine oder zwei Doppelschichtanordnungen aufweist.

6. Halterung nach einem der vorstehenden Ansprüche, **dadurch gekennzeichnet, daß** das Material mit hoher akustischer Impedanz mindestens einen der folgenden Werkstoffe aufweist: Aluminiumnitrid, Kupfer, Nickel, Wolfram oder Platin, Molybdän.

7. Halterung nach einem der vorstehenden Ansprüche, **dadurch gekennzeichnet, daß** die Schicht aus einem Material mit hoher akustischer Impedanz eine Dicke zwischen 0,3 und 3,2 $\mu$m hat.

8. Halterung nach einem der vorstehenden Ansprüche, **dadurch gekennzeichnet, daß** die Schicht aus einem Material mit niedriger akustischer Impedanz eine Dicke von weniger als 0,7 $\mu$m, vorzugsweise zwischen 0,3 und 0,7 $\mu$m, hat.

9. Akustischer Resonator (4), der ein aktives Element (6) und eine Halterung (7) nach Anspruch 1 aufweist.

10. Resonator nach Anspruch 9, **dadurch gekennzeichnet, daß** das aktive Element (6) mindestens eine zwischen Elektroden (8,10) angeordnete piezoelektrische Schicht (9) aufweist.

11. Integrierte Schaltung (1), die ein Substrat (2), eine Zwischenverbindungsanordnung und einen akustischen Resonator (4) aufweist, der mit einem aktiven Element (6) und einer Halterung (7) nach Anspruch 1 ausgestattet ist.

12. Schaltung nach Anspruch 11, **dadurch gekennzeichnet, daß** der akustische Resonator (4) oberhalb der Zwischenverbindungsanordnung (3) angeordnet ist.

13. Schaltung nach Anspruch 11, **dadurch gekennzeichnet, daß** der akustische Resonator (4) in der Ebene der Zwischenverbindungsanordnung (3) angeordnet ist.

14. Schaltung nach einem der Ansprüche 11 bis 13, **dadurch gekennzeichnet, daß** die Schicht aus einem Material mit niedriger akustischer Impedanz in gleicher Höhe wie eine Zwischenverbindungsschicht angeordnet ist.

## FIG.1

## FIG.2

# FIG.3